# FASCICULE DE BREVET EUROPEEN

(11) **EP 0 440 127 B1**
(45) Date de publication et mention de la délivrance du brevet: **10.04.1996**
(21) Numéro de dépôt: 91101054.4
(22) Date de dépôt: 28.01.1991
(51) Int. Cl.: H01L 39/14, H01L 39/24

(54) **Conducteur supraconducteur protégé des transitions partielles**
Gegen partielle Übergänge geschützter Supraleiter
Superconductor protected against partial transitions

(30) Priorité: 29.01.1990 FR 9000992
(43) Date de publication de la demande: 07.08.1991
(73) Titulaire: GEC ALSTHOM SA, F-75116 Paris (FR)
(72) Inventeur: Verhaege, Thierry, F-91160 Saulx Les Chartreux (FR); Pham, Van Doan, F-69330 Meyzieu (FR); Lacaze, Alain, F-90850 Essert (FR)
(74) Mandataire: Weinmiller, Jürgen

(56) Documents cités:
- EP-A- 0 156 626
- EP-A- 0 230 567
- EP-A- 0 409 269
- IEEE TRANSACTIONS ON MAGNETICS, vol. 21, no. 2, mars 1985, pages 157-160, New York, US; Y. TAKAHASHI et al.: "Development of 12 T-10 kA A1-stabilized Nb3Sn conductor for TMC-II"
- IEEE TRANSACTIONS ON MAGNETICS, vol. 25, no. 2, mars 1989, pages 1484-1487, New York, US; & APPLIED SUPERCONDUCTIVITY CONFERENCE, San Francisco, 21- 24 août 1988; H. TSUJI et al.: "Recent progress in the demo poloidal coil program"

## Description

La présente invention concerne un conducteur supraconducteur et notamment un conducteur supraconducteur protégé des transitions partielles.

Il convient de rappeler tout d'abord ce que l'on appelle "conducteur", "brin", "filament".

Par "conducteur" il faut entendre conducteur assemblé, constitué d'éléments séparables qui sont ici les brins. Le brin est le plus petit élément séparable (sous forme de fil). Un brin supraconducteur est formé de filaments supraconducteurs noyés dans une matrice métallique. Le brin central ou l'âme centrale est un composite métallique.

Le filament est un sous-ensemble homogène du brin composite.

On connaît diverses configurations de conducteurs supraconducteurs.

Dans le cas des conducteurs multibrins, les brins supraconducteurs peuvent être torsadés autour d'un brin central supraconducteur, ou en acier inoxydable, ou encore en alliage de cuivre, muni ou non d'une gaine isolante.

Le brevet européen n^{o} 0037544 décrit un autre type de configuration de conducteur supraconducteur multibrins plat, comportant une âme centrale formée d'un ruban de cuivre pourvu d'un "séparateur" isolant.

On sait que les conducteurs supraconducteurs peuvent subir accidentellement, ou dans des conditions de fonctionnement particulières, des transitions partielles, c'est-à-dire le passage à l'état résistif d'une zone limitée du conducteur ; cette zone est initialement très petite, puis s'étend progressivement en raison de l'échauffement par effet Joule. L'échauffement rapide et intense, et les tensions élevées, qui apparaissent aux bornes de la zone transitée, risquent d'endommager le conducteur.

Pour modérer les effets des transitions partielles, on prévoit généralement pour les brins supraconducteurs une matrice comportant, dans une proportion importante pouvant aller jusqu'à 80% et même 90%, un métal bon conducteur, tel que le cuivre ou l'aluminium ; on cherche alors à détecter la transition et à réduire le courant aussi vite que possible. Il s'avère que le délai de réaction et le temps nécessaire à la réduction des courants sont parfois trop longs pour que l'on puisse éviter des surchauffes ou des surtensions susceptibles de dégrader les brins.

Dans l'article paru dans IEEE TRANSACTIONS ON MAGNETICS, vol.MAG.17 n° 5, september 1981, "High sensitive quench detection method using an integrated test wire", on décrit un dispositif de protection d'un conducteur supraconducteur comprenant un brin, ou une âme centrale en alliage cupronickel, sur lequel est prévu un détecteur de tension, associé à des moyens de traitement de signal pour introduire dans le circuit du conducteur des résistances destinées à réduire le courant.

La complexité d'un tel dispositif de protection multiplie les risques de défaillance.

La présente invention a pour but d'éviter ces inconvénients et de permettre une protection plus simple et plus efficace des conducteurs supraconducteurs.

La présente invention a pour objet un conducteur supraconducteur protégé des transitions partielles selon la revendication 1 comprenant des brins supraconducteurs autour d'au moins un brin central non supraconducteur, ou d'au moins une âme centrale non supraconductrice, isolé électriquement desdits brins supraconducteurs, au moins au niveau des deux extrémités dudit conducteur, ledit brin central, ou ladite âme centrale, étant connecté électriquement auxdits brins supraconducteurs, et ledit brin central, ou ladite âme centrale, se composant d'au moins un filament d'un métal non supraconducteur, dont la résistivité à 4,2 K est inférieure à10⁻⁹ Ω.m, noyé dans une matrice en alliage métallique dont la résistivité à cette température est supérieure à 10⁻⁸ Ω.m.

Ledit métal non supraconducteur est de préférence choisi parmi les métaux non alliés ayant un taux d'impureté égale au taux d'impureté des métaux, connus sous les normes CuOFHC ou CuC2, ou l'aluminium.

Sa résistivité à basse température peut, si besoin est, être réduite par un traitement thermique approprié jusqu'à des valeurs de l'ordre de 10⁻¹⁰ Ω.m. Ce type de matériau présente l'avantage d'avoir une résistivité fortement dépendante de la température, par exemple cent fois plus élevée à 300 K qu'à 4,2 K.

Ledit alliage métallique est de préférence du cupronickel à 30% de nickel ; sa résistivité est voisine de 4 x 10⁻⁷ Ω.m à toutes les températures.

Si on appelle pₒ le pourcentage de métal de basse résistivité dans le brin central, ou l'âme centrale, et p₁ le pourcentage de métal de basse résistivité présent dans les brins supraconducteurs pₒ et p₁ doivent de préférence être choisis de la façon suivante :
- pour 0 < p₁ < 0,5% , 1% < pₒ < 10%
- pour 0,5% < p₁ < 20% , 2 p₁ < pₒ < 5 p₁.

Après l'amorçage d'une transition partielle, le brin central dérive une partie du courant, s'échauffe et échauffe par diffusion thermique les brins supraconducteurs qui l'entourent, suivant toute leur longueur comprise entre les contacts électriques. Le phénomène entraîne rapidement la transition des brins supraconducteurs sur toute le longueur considérée.
La résistance du brin central croît rapidement avec la température, et les brins transités présentent également une résistance élevée, de sorte que la décroissance du courant peut suffire pour éviter tout risque de dégradation.

Le choix des valeurs de pₒ et p₁ mentionnées ci-dessus constitue un compromis entre les risques de dégradation des brins supraconducteurs et les risques de dégradation du brin central. En effet si pₒ est trop faible pour une valeur donnée de p₁, l'effet Joule dans le brin central est réduit de sorte que l'échauffement et la transition sont retardés. Si par contre pₒ est trop élevé pour une valeur donnée de p₁, l'effet Joule intense risque de détruire le brin central.

Si nécessaire, le passage d'un courant dans le brin central peut servir de signal pour commander la mise en série dans le circuit de résistances supplémentaires. Il s'agit là d'un circuit de protection externe complémentaire plus simple que les dispositifs de protection de l'art antérieur.

L'énergie globalement dissipée dans un conducteur selon l'invention est importante, mais elle est mieux répartie et la température maximale atteinte est considérablement réduite.

Selon une variante de mise en oeuvre, le conducteur selon l'invention comporte deux brins non supraconducteurs, de type précédemment défini et connectés électriquement respectivement à des points Pᵢ et P'ᵢ desdits brins supraconducteurs, chaque point P'ᵢ étant compris entre deux points Pᵢ.

On obtient encore une transition complète par une réaction en cascade d'un tronçon au tronçon suivant.

D'autres caractéristiques et des avantages de la présente invention apparaîtront au cours de la description suivante de modes de réalisation donnés à titre illustratif mais non limitatif.

Dans le dessin annexé :
- La figure 1 est une vue très schématique en coupe d'un exemple de conducteur selon l'invention à l'échelle x 200.
- La figure 2 est une vue schématique agrandie en coupe (x 20.000) du détail référencé II sur la figure 1.
- La figure 3A est un schéma très simplifié montrant le fonctionnement du conducteur des figures 1 et 2 en cas de transition.
- La figure 3B montre une variante du schéma de la figure 3A.
- La figure 4 est un schéma très simplifié d'une variante de conducteur selon l'invention.

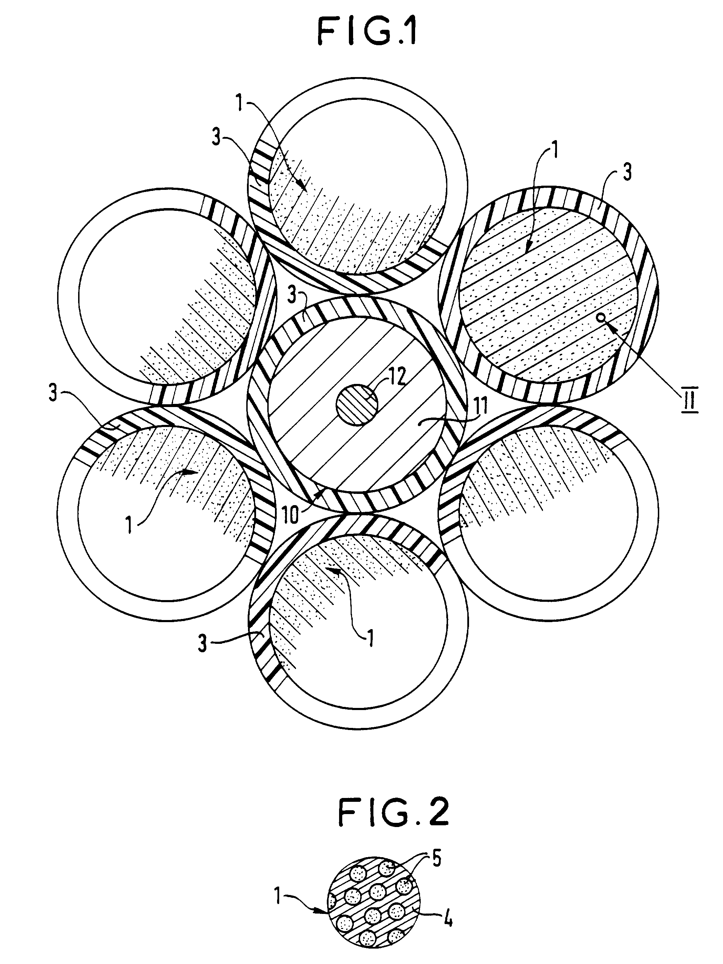

On voit dans la figure 1 un conducteur assemblé en toron comportant six brins supraconducteurs 1 entourant un brin 10 non supraconducteur.
Chaque brin 1 comprend (cf figure 2) une matrice 4 en alliage cupronickel avec des filaments 5 en niobium-titane ; il est entouré d'une gaine 3 en isolant électrique.

Le brin central 10 est constitué d'un filament de cuivre 12 entouré d'une matrice en alliage cupronickel 11 ; il est également muni d'une gaine 3 en isolant électrique. Le pourcentage pₒ de cuivre dans ce brin 10 est de 5%.

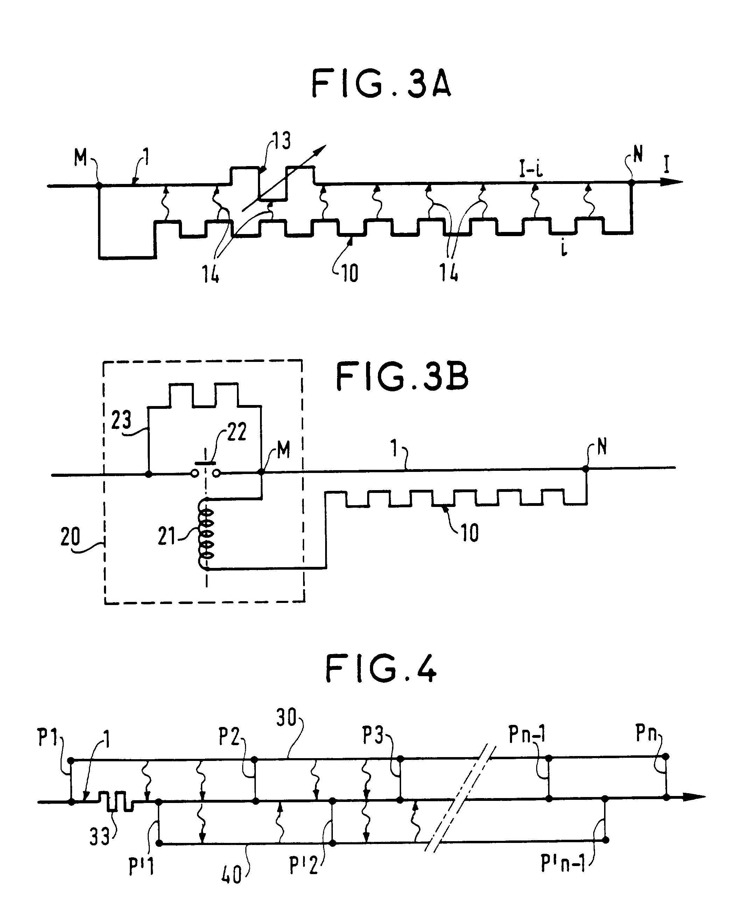

Comme cela apparaît très schématiquement dans la figure 3A le brin 10 est connecté électriquement aux deux extrémités M et N des brins 1. En cas de transition partielle au niveau de la zone 13 d'un brin 1, le brin 10 dérive une partie i du courant I, s'échauffe et échauffe par diffusion thermique les brins 1 (flèches 14). Un échauffement de quelques K des brins 1 suffit à les faire transiter sur toute la longueur comprise entre M et N. Par la suite la résistivité du brin central s'élève avec sa température de sorte que le courant i diminue et que l'échauffement du brin central se ralentit.

Pour assurer une sécurité supplémentaire on peut ajouter un dispositif de protection externe 20, comme cela apparaît dans la figure 3B. Il s'agit d'un dispositif extrêmement simple comprenant une bobine 21 en série avec le brin 1, qui, en cas de passage d'un courant i, ouvre un contact 22 qui met en série des resistances 23.

Dans le schéma de la figure 4, les brins 1 entourent deux brins non supraconducteurs 30 et 40. Si P₁ et Pₙ sont les extrémités du brin 1, le brin 30 est connecté aux brins 1 au niveau de ces points, mais également au niveau de points intermédiaires P₂ ...P ₙ₋₁ . Quant au brin 40, il est connecté au brin 1 en d'autres points P'₁...P'ₙ₋₁ .

En cas de transition partielle dans la zone 33 des brins 1, il se produit des échanges thermiques et transitions en cascade dans la zone P₁ P'₁ P₂, puis dans la zone P'₁ P₂ P'₂ ...jusqu'à Pₙ.

## Revendications

1. Conducteur supraconducteur protégé des transitions partielles comprenant des brins supraconducteurs (1) autour d'au moins un brin non supraconducteur (10, 30, 40), ledit brin non supraconducteur (10, 30, 40) étant composé d'au moins un filament (12) d'un métal non supraconducteur de résistivité inférieure à 10⁻⁹ Ω.m à une température de 4,2 K, ledit filament (12) étant noyé dans une matrice (11) en alliage métallique, ledit brin non supraconducteur étant isolé électriquement desdits brins supraconducteurs (1), la matrice (11) en alliage métallique ayant une résistivité supérieure à 10⁻⁸ Ω.m à une température de 4,2 K, et ledit brin non supraconducteur (10, 30, 40) étant connecté électriquement à chacune des deux extrémités (M, N) de chaque brin supraconducteur (1).

2. Conducteur supraconducteur selon la revendication 1 caractérisé en ce que ledit métal non supraconducteur est choisi parmi les métaux non alliés ayant un taux d'impureté égal au taux d'impureté des métaux connus sous les normes CuOFHC ou CuC2.

3. Conducteur supraconducteur selon la revendication 1 ou 2 caractérisé en ce que p₀ étant le pourcentage de métal non supraconducteur présent dans le brin non supraconducteur (10, 30, 40) et p₁ étant le pourcentage de métal non supraconducteur présent dans les brins supraconducteurs (1),
- pour p₁ inférieur à 0,5 %, p₀ doit être compris entre 1 % et 10 %, et
- pour p₁ compris entre 0,5% et 20 %, p₀ doit être compris entre 2 p₁ et 5 p₁.

4. Conducteur supraconducteur selon l'une quelconque des revendications 1 à 3 caractérisé en ce qu'il comprend deux brins non supraconducteurs (30, 40), chacun connecté électriquement à une série de points (P₁, P₂, **...,** Pₙ ; P'₁, P'₂, ... , P'ₙ) desdits brins supraconducteurs (1), chaque point de connexion avec l'un des brins non supraconducteur (30, 40) étant compris entre deux points de connexion avec l'autre brin non supraconducteur(40, 30).

5. Conducteur supraconducteur selon l'une quelconque des revendications 1 à 4 caractérisé en ce que le brin non supraconducteur (10, 30, 40) est monté en série avec une bobine (21) de commande (22) de résistances en série (23) d'un dispositif de protection complémentaire (20).

6. Conducteur supraconducteur selon l'une quelconque des revendications 1 à 5 caractérisé en ce que ledit métal non supraconducteur est de l'aluminium.

7. Conducteur supraconducteur selon l'une quelconque des revendications 1 à 6 caractérisé en ce que chaque brin supraconducteur (1) ou non supraconducteur (10, 30, 40) est entouré d'une gaine (3) électriquement isolante.

## Patentansprüche

1. Gegen partielle Übergänge in den normalleitenden Zustand geschützter Supraleiter, der supraleitende Adern (1) um mindestens eine nicht-supraleitende zentrale Ader (10, 30, 40) herum enthält, wobei die nicht-supraleitende zentrale Ader (10, 30, 40) aus mindestens einem Faden (12) eines nicht-supraleitenden Metalls mit einem spezifischen Widerstand von weniger als 10⁻⁹Ωm bei einer Temperatur von 4,2 K besteht, der in eine Matrix (11) aus einer Metallegierung eingetaucht ist, wobei die nicht-supraleitende Ader elektrisch gegen die supraleitenden Adern (1) isoliert ist, wobei der spezifische Widerstand der Matrix (11) aus einer Metallegierung bei einer Temperatur von 4,2 K höher als 10⁻⁸Ωm ist und wobei die nicht-supraleitende Ader (10, 30, 40) elektrisch mit jedem der beiden Enden (M, N) jeder supraleitenden Ader (1) verbunden ist.

2. Supraleiter nach Anspruch 1, dadurch gekennzeichnet, daß das nicht supraleitende Metall aus den unlegierten Metallen ausgewählt wird, die einen Verunreinigungsgrad gleich dem Verunreinigungsgrad der Metalle aufweist, die unter den Normen CuOFHC oder CuC2 bekannt sind.

3. Supraleiter nach Anspruch 1 oder 2, dadurch gekennzeichnet, daß, wenn p₀ der Prozentsatz des in der nicht-supraleitenden Ader (10, 30, 40) vorhandenen nicht-supraleitenden Metalls und p₁ der Prozentsatz des in den supraleitenden Adern (1) vorhandenen nicht-supraleitenden Metalls ist,
- für p₁ < 0,5% der Wert von p₀ zwischen 1% und 10% liegen muß,
- für p₁ zwischen 0,5% und 20% der Wert von p₀ zwischen 2p₁ und 5p₁ liegen muß.

4. Supraleiter nach einem beliebigen der Ansprüche 1 bis 3, dadurch gekennzeichnet, daß er zwei nicht-supraleitende Adern (30, 40) aufweist, die je elektrisch mit einer Reihe von Punkten (P₁, P₂, ... Pₙ; P'₁, P'₂, ... P'ₙ) der supraleitenden Adern (1) verbunden sind, wobei jeder Verbindungspunkt mit der einen nicht-supraleitenden Ader (30, 40) zwischen zwei Verbindungspunkten mit der anderen nicht-supraleitenden Ader (40, 30) liegt.

5. Supraleiter nach einem beliebigen der Ansprüche 1 bis 3, dadurch gekennzeichnet, daß die nicht-supraleitende Ader (10, 30, 40) mit einer Spule (21) zur Steuerung (22) der Einfügung von Serien-Widerständen (23) einer zusätzlichen Schutzvorrichtung (20) in Reihe geschaltet ist.

6. Supraleiter nach einem beliebigen der Ansprüche 1 bis 5, dadurch gekennzeichnet, daß das nicht-supraleitende Metall Aluminium ist.

7. Supraleiter nach einem beliebigen der Ansprüche 1 bis 6, dadurch gekennzeichnet, daß jede supraleitende Ader (1) oder nicht supraleitende Ader (10, 30, 40) von einer elektrisch isolierenden Hülle (3) umgeben ist.

## Claims

1. Superconductor protected against partial transition comprising superconductor strands (1) around at least one non-superconductor strand (10, 30, 40), said non-superconductor strands (10, 30, 40) comprising at least one non-superconductor metal filament (12) whose resistivity at 4.2 K is less than 10⁻⁹ Ω.m embedded in a metal alloy matrix (11), said non-superconductor strand being electrically insulated from said superconductor strands (1), the metal alloy matrix (11) having a resistivity greater than 10⁻⁸ Ω.m at a temperature of 4.2 K, both ends (M, N) of said non-superconductor strand (10, 30, 40) being electrically connected to each superconductor strand (1).

2. Superconductor according to claim 1 characterised in that said non-superconductor metal is a non-alloyed metal having an impurity content equal to that of CuOFHC or CuC2.

3. Superconductor according to claim 1 or claim 2 characterised in that, p₀ being the percentage of non-superconductor metal present in the non-superconductor strand (10, 30, 40) and p₁ being the percentage of non-superconductor metal present in the superconductor strands (1),
- for p₁ less than 0.5%, p₀ must be between 1% and 10%, and,
- for p₁ between 0.5% and 20%, p₀ must be between 2 p₁ and 5 P₁.

4. Superconductor according to any one of claims 1 to 3 characterised in that it comprises two non-superconductor strands (30, 40) each connected electrically to a series of points (P₁, P₂, ..., Pₙ; P'₁, P'₂, ..., P'ₙ) of said superconductor strands (1), each point of connection to one of the non-superconductor strands (30, 40) being disposed between two points of connection to the other non-superconductor strand (40, 30).

5. Superconductor according to any one of claims 1 to 4 characterised in that the non-superconductor strand (10, 30, 40) is connected in series with a coil (21) of a control device (22) for series resistors (23) of an additional protection device (20).

6. Superconductor according to any one of claims 1 to 5 characterised in that said non-superconductor metal is aluminium.

7. Superconductor according to any one of claims 1 to 6 characterised in that each superconductor strand (1) or non-superconductor strand (10, 30, 40) is surrounded by an electrically insulative jacket (3).
